(19) Europäisches Patentamt
European Patent Office
Office européen des brevets

(11) EP 1 029 258 B1

(12) **EUROPEAN PATENT SPECIFICATION**

(45) Date of publication and mention of the grant of the patent:
**12.05.2004 Bulletin 2004/20**

(21) Application number: **98957951.1**

(22) Date of filing: **13.11.1998**

(51) Int Cl.[7]: **G03F 7/00**, G03F 7/038, G03F 7/075

(86) International application number:
**PCT/US1998/024318**

(87) International publication number:
**WO 1999/026112 (27.05.1999 Gazette 1999/21)**

(54) **HOLOGRAPHIC MEDIUM AND PROCESS**
HOLOGRAPHISCHES AUFZEICHNUNGSMATERIAL UND VERFAHREN
PROCEDE ET SUPPORT HOLOGRAPHIQUE

(84) Designated Contracting States:
**DE FR GB NL**

(30) Priority: **13.11.1997 US 970066**

(43) Date of publication of application:
**23.08.2000 Bulletin 2000/34**

(73) Proprietor: **Polaroid Corporation**
**Waltham, MA 02451 (US)**

(72) Inventors:
- **DHAL, Pradeep, K.**
**Westford, Massachusetts 01886 (US)**
- **INGWALL, Richard, T.**
**Newton, MA 02165 (US)**
- **KOLB, Eric, S.**
**Acton, MA 01720 (US)**
- **LI, Hsin, Yu**
**Lexington, MA 02173 (US)**
- **WALDMAN, David, A.**
**Acton, MA 01720 (US)**

(74) Representative: **Westendorp, Michael, Dr. et al**
**Patentanwälte**
**Splanemann Reitzner**
**Baronetzky Westendorp**
**Rumfordstrasse 7**
**80469 München (DE)**

(56) References cited:
**EP-A- 0 672 953**
**WO-A-97/13183**
**WO-A-97/42549**
**GB-A- 2 137 626**
**US-A- 3 936 557**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 029 258 B1

## Description

This invention relates to a process for preparing a volume hologram and to a volume holographic recording medium.

In prior art processes for the formation of volume-phase holograms, interference fringes are formed within a holographic recording medium comprising a homogeneous mixture of at least one polymerizable monomer or oligomer and a polymeric binder; the polymerizable monomer or oligomer must of course be sensitive or sensitized to the radiation used to form the interference fringes. In the illuminated regions of the fringes, the monomer or oligomer undergoes polymerization to form a polymer that has a refractive index different from that of the binder. Diffusion of the monomer or oligomer into the illuminated regions, with consequent chemical segregation of binder from these areas and its concentration in the non-illuminated regions, produces spatial separation between the polymer formed from the monomer or oligomer and the binder, thereby providing the refractive index modulation needed to form the hologram. Typically, after the holographic exposure, a post-imaging blanket exposure of the medium to actinic radiation is required to complete the polymerization of the monomer or oligomer and fix the hologram.

For example, JP-A-05-04014 describes a holographic recording medium comprising an ethylenically unsaturated polymerizable monomer or monomers, a minor proportion of a photo-radical polymerization initiator and an epoxy resin, which appears to be a binder. It is stated that upon holographic exposure the medium undergoes efficient separation of the polymer derived from the monomer and the epoxy resin, and that the medium can be fully cured by after-exposure with ultraviolet radiation or heat treatment.

Also, a known dry-process medium for holographic recording (sold commercially by E.I. du Pont de Nemours, Inc., Wilmington, Delaware, United States of America) comprises a polymeric binder, a monomer capable of radical-initiated polymerization, and a photoinitiator (a term which is used herein to include polymerization initiators which are sensitive to radiation outside the visible range, for example ultra-violet radiation). Such a radical-polymerized medium suffers from a number of disadvantages, including severe inhibition of the radical polymerization by atmospheric oxygen, which requires precautions to exclude oxygen from the holographic medium. Also, radical polymerization often results in substantial shrinkage of the medium, with consequent distortion of the holographic image. Furthermore, radical polymerization often results in high intensity reciprocity failure, and it is difficult to record efficiently holograms having low spatial frequency components. The commercial du Pont medium may require a lengthy thermal post-exposure treatment to further develop the index modulation of the hologram, and this thermal treatment increases the shrinkage of the hologram and distorts the fringe pattern. Finally, the du Pont medium suffers from optical inhomogeneities which impair the signal-to-noise ratio of the material, and its semisolid properties tend to result in variations in coating thickness.

One important potential use for volume holograms is in digital data storage; the three dimensional nature of a volume hologram, coupled with the high information density and parallel read/write capability which can be achieved, renders volume holograms very suitable for use in high capacity digital data storage; in theory, compact devices having storage capacities in the terabyte ($10^{12}$ byte) range should readily be achievable. However, the aforementioned disadvantages of radical-polymerized holographic media, especially the lengthy thermal treatment, which are particularly serious when the media are to be used for digital data storage, have hitherto hindered the development of holographic data storage devices.

WO 97/13183 describes holographic recording media which rely upon cationic polymerization without requiring free radical polymerization, thereby eliminating the aforementioned problems of media which use free radical polymerization. However, another important consideration in holographic recording media for digital data storage is the shrinkage of the medium during exposure. Volume phase holograms of digital data (recorded using a transparency or addressable spatial light modulator, optionally in conjunction with a randomized phase mask; see for example F. M. Smits and L. E. Gallagher, Design considerations for a semipermanent optical memory, Bell Syst. Tech. J., 46, 1267 (1967), C. B. Burckhardt and E. T. Doherty, Appl. Opt., 8, 2479 (1969), L. d'Auria, J. P. Huignard, C. Slezak, and E. Spitz, Experimental holographic read-write memory using 3-D storage, Appl. Opt., *13(4),* 808 (1974), and F. H. Mok, Angle-multiplexed storage of 5000 holograms in lithium niobate, Opt Lett., *18(11),* 915 (1993)) are arranged in pages, and consist of a range of grating slant angles, each angle being formed from interference of the distinct spatial frequency components of the signal beam with the reference beam. Encoding schemes such as the use of paraphase coding, data coding based upon a randomized arrangement of binary digits, and representation of data in Hamming, Reed-Solomon, and channel codes, increase the reliability of volume holographic data storage by minimizing the effect of non-uniformities in diffraction efficiency, but although error correction codes reduce the impact of various noise contributions, they inherently involve some reduction in storage capacity. Accordingly, in designing holographic recording materials for use in digital data storage, it is important to minimize physical material contributions to noise, such as that arising from volume shrinkage of the medium during imaging.

The slant angles of volume phase holograms recorded in photopolymers are altered by anisotropic volume shrinkage, which is attributed to the increase in density occurring during the photopolymerization reactions. This shrinkage causes angular deviations in the Bragg profile which can exceed the angular bandwidth, even for moderate slant angles. For example, a volume phase plane-wave transmission hologram, with thickness of about 100 μm, and recorded with non-slant geometry, exhibits an angular profile with a Bragg peak having a full width at half height of about 0.47°. If the recording medium only undergoes shrinkage in the transverse (thickness) direction then no shift occurs in the Bragg peak angle for a non-slant hologram. For slant-fringe transmission holograms, however, shifts in the Bragg peak angle are observed due to shrinkage, regardless of shrinkage direction. The magnitude of the angle shift is dependent on the slant angle and the amount of shrinkage. The du Pont photopolymer film, HRF-150-38, exhibits a Bragg angle shift of about 2.5° for a hologram with a moderate slant angle $\phi$ of 18°; see U.-S. Rhee, H. J. Caulfield, C. S. Vikram, and J. Shamir, Dynamics of hologram recording in du Pont photopolymer, Appl. Opt., *34(5),* 846 (1995). For a hologram of 100 μm thickness with this slant angle, the full width at half height of the Bragg peak is about 0.7° for a read beam angle 12.5° from the direction normal to the surface. For a hologram of 200 μm thickness the full width at half height is one half of the value for a hologram of 100 μm thickness. Image reconstruction (readout) of a single image, which comprises multiple gratings, is therefore likely to result in lack of image fidelity and/or distortion, unless the shrinkage is reduced to extremely low levels.

It has now been discovered that holographic recording media based upon a mixture of epoxide monomers of differing functionality record with reduced shrinkage, rendering these media especially suitable for use in digital data storage applications. These recording media also have lower threshold exposure energy requirements, thus allowing increased writing speed in data storage applications.

Accordingly, this invention provide a process for preparing a hologram, which process comprises: providing a volume holographic recording medium comprising an acid generator capable of producing an acid upon exposure to actinic radiation; a binder, and a material capable of undergoing cationic polymerization initiated by the acid produced from the acid generator, and passing into the medium a reference beam of coherent actinic radiation to which the acid generator is sensitive and an object beam of the same coherent actinic radiation, thereby forming within the medium an interference pattern and thereby forming a volume hologram within the medium. The process of this invention is characterized in that the material capable of undergoing cationic polymerization comprises a difunctional epoxide monomer or oligomer; and a polyfunctional epoxide monomer or oligomer.

The term "polyfunctional" is used herein in accordance with conventional usage in the chemical arts to mean a material in which each molecule has at least three groups of the specified functionality, in the present case at least three epoxy groups.

This invention also provides a volume holographic recording medium comprising an acid generator capable of producing an acid upon exposure to actinic radiation; a binder; and a material capable of undergoing cationic polymerization initiated by the acid produced from the acid generator, this medium being characterized in that the material capable of undergoing cationic polymerization comprises a difunctional epoxide monomer or oligomer, and a polyfunctional epoxide monomer or oligomer, and

said binder does not inhibit cationic polymerization of said difunctional and polyfunctional monomers or oligomers and the refractive index of said binder is significantly different from that of the polymerized difunctional and polyfunctional monomers or oligomers.

The accompanying drawing shows schematically the grating vector components in the xz-plane of a hologram of the present invention, as discussed in Example 4 below.

As already mentioned, the volume olographic recording medium of the present invention uses as its polymerizable components a difunctional epoxide monomer or oligomer, and a polyfunctional epoxide monomer or oligomer. For convenience and brevity, the description below will normally refer only to monomers, although it should be understood that oligomers can be substituted for the monomers if desired. Similarly, although the invention will mainly be described herein assuming that only one difunctional monomer and one polyfunctional monomer is present in the holographic recording medium, mixtures of more than one of each type of monomer may be used if desired, as may more than one binder. Finally, it should be noted that in both the difunctional and the polyfunctional monomers, the various epoxy functions need not all be the same.

It is preferred that at least one, and preferably both, of the difunctional and polyfunctional epoxide monomers used in the present invention be siloxanes, since siloxanes are generally compounds stable on prolonged storage but capable of undergoing rapid and well-understood cationic polymerization. The preferred type of epoxy group in both monomers is a cycloalkene oxide group, especially a cyclohexene oxide group, since the reagents needed to prepare this type of grouping are readily available commercially and are inexpensive. A particularly preferred group of difunctional monomers are those in which two cyclohexene oxide groupings are linked to an Si-O-Si grouping; these monomers have the advantage of being compatible with polysiloxane binders. Examples of such monomers include those of the formula:

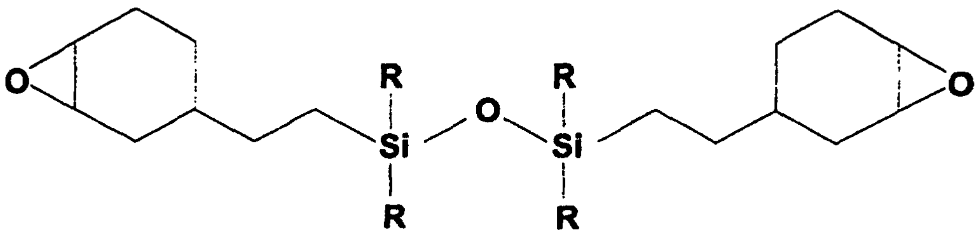

(I)

where each R independently is an alkyl group containing not more than about 6 carbon atoms. The compound in which each group R is a methyl group is available from Polyset Corporation, Inc., Mechanicsville, New York, United States of America, under the tradename PC-1000, and the preparation of this specific compound is described in, *inter alia,* US-A-5 387 698 and US-A-5 442 026.

A variety of tri-, tetra- and higher polyepoxysiloxanes have been found useful as the polyfunctional monomer in the present medium and process. One group of such polyepoxysiloxanes are the cyclic compounds of the formula:

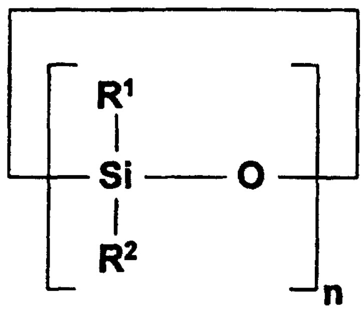

(II)

wherein each group $R^1$ is, independently, a monovalent substituted or unsubstituted $C_{1-12}$ alkyl, $C_{1-12}$ cycloalkyl, aralkyl or aryl group; each group $R^2$ is, independently, $R^1$ or a monovalent epoxy functional group having 2-10 carbon atoms, with the proviso that at least three of the groups $R^2$ are epoxy functional; and *n* is from 3-10. The preparation of these cyclic compounds is described in, *inter alia,* US-A-5 037 861; US-A-5 260°399; US-A-5 387 698; and US-A-5 583 194. One specific useful polymer of this type is 1,3,5,7-*tetrakis*(2-(3,4-epoxycyclohexyl)ethyl)-1,3,5,7-tetramethylcyclotetrasiloxane.

The preferred polyfunctional epoxide monomers are those of the formula:

$$R^3Si(OSi(R^4)_2R^5)_3 \qquad (III)$$

$R^3$ is an $OSi(R^4)_2R^5$ grouping, or a monovalent substituted or unsubstituted $C_{1-12}$ alkyl, $C_{1-12}$ cycloalkyl, aralkyl or aryl group; each group $R^4$ is, independently, a monovalent substituted or unsubstituted $C_{1-12}$ alkyl, $C_{1-12}$ cycloalkyl, aralkyl or aryl group; and each group $R^5$ is, independently, a monovalent epoxy functional group having 2-10 carbon atoms; this type of monomer may hereinafter be called a "star type" monomer. The preparation of these monomers is described in, *inter alia,* US-A-5 169 962; US-A-S 260 399; US-A-5 387 698; and US-A-5 442 026. One specific monomer of this type found useful in the present process is that in which $R^3$ is a methyl group or an $OSi(R^4)_2R^5$ grouping; each group $R^4$ is a methyl group, and each group $R^5$ is a 2-(3,4-epoxycyclohexyl)ethyl grouping.

A second preferred group of polyfunctional monomers for use in the present medium and process are those of the formula:

$$(R^6)_3SiO[SiR^7R^8O]_p[Si(R^7)_2O]_qSi(R^6)_3 \qquad (IV)$$

each group $R^6$ is, independently, a monovalent substituted or unsubstituted $C_{1-12}$ alkyl, $C_{1-12}$ cycloalkyl, or phenyl group; each group $R^7$ is, independently, a monovalent substituted or unsubstituted $C_{1-12}$ alkyl, $C_{1-12}$ cycloalkyl, aralkyl or aryl group; each group $R^8$ is, independently, a monovalent epoxy functional group having 2-10 carbon atoms, and p is *an integer equal to or greater than* 3, and q *is an integer.* These monomers may be prepared by processes analogous

to those described in US-A-5 523 374, which involve hydrosilylation of the corresponding hydrosilanes with the appropriate alkene oxide using a platinum or rhodium catalyst. Specific monomers of this type found useful in the present process are those in which each group $R^6$ and $R^7$ is an alkyl group, and of these one especially preferred monomer is that in which $R^8$ is an 2-(3,4-epoxycyclohexyl)ethyl grouping and *p* and *q* are approximately equal.

The binder used in the present medium and process should of course be chosen such that it does not inhibit cationic polymerization of the monomers used, and such that its refractive index is significantly different from that of the polymerized monomer or oligomer. Preferred binders for use in the present process are polysiloxanes and polystyrenes. Because of the wide variety of polysiloxanes available and the well-documented properties of these polymers, the physical, optical and chemical properties of the polysiloxane binder can all be adjusted for optimum performance in the recording medium.

The efficiency of the holograms produced by the present process is markedly dependent upon the particular binder employed. Although those skilled in the holographic art will have no difficulty in selecting an appropriate binder by routine empirical tests, in general it may be stated that poly(methyl phenyl siloxanes) and oligomers thereof, such as the trimer sold by Dow Chemical Company under the trade name Dow 705, have been found to give efficient holograms.

The acid generator used in the present recording medium produces an acid upon exposure to the actinic radiation. The term "acid generator" is used herein to refer to the component or components of the medium that are responsible for the radiation-induced formation of acid. Thus, the acid generator may comprise only a single compound that produces acid directly. Alternatively, the acid generator may comprise an acid generating component which generates acid and one or more sensitizers which render the acid generating component sensitive to a particular wavelength of actinic radiation, as discussed in more detail below The acid produced from the acid generator may be either a Bronstead acid or a Lewis acid, provided of course that the acid is of a type and strength which will induce the cationic polymerization of the monomer. When the acid generator produces a Bronstead acid, this acid preferably has a $pK_a$ less than about 0. Known superacid precursors such as diazonium, sulfonium, phosphonium and iodonium salts may be used in the present medium, but iodonium salts are generally preferred. Diaryliodonium salts have been found to perform well in the present media, with specific preferred diaryliodonium salts being (4-octyloxyphenyl)phenyliodonium hexafluoroantimonate and ditolyliodonium *tetrakis*(pentafluorophenyl)borate. Among the Lewis acid generators, ferrocenium salts have been found to give good results. in the present media, a specific preferred ferrocenium salt being cyclopentadienyl cumene iron(II) hexafluorophosphate, available commercially under the tradename Irgacure 261 from Ciba-Geigy Corporation, 7 Skyline Drive, Hawthorne New York 10532-2188, United States of America. This material has the advantage of being sensitive to 476 or 488 nm visible radiation without any sensitizer, and can be sensitized to other visible wavelengths as described below.

In the absence of any sensitizer, iodonium salts are typically only sensitive to radiation in the far ultra-violet region, below about 300 nm, and the use of far ultra-violet radiation is inconvenient for the production of holograms because for a given level of performance ultra-violet lasers are substantially more expensive than visible lasers. However, it is well known that, by the addition of various sensitizers, iodonium salts can be made sensitive to various wavelengths of actinic radiation to which the salts are not substantially sensitive in the absence of the sensitizer. In particular, iodonium salts can be sensitized to visible radiation with sensitizers using certain aromatic hydrocarbons substituted with at least two alkynyl groups, a specific preferred sensitizer of this type being 5,12-*bis*(phenylethynyl) naphthacene. This sensitizer renders iodonium salts sensitive to the 514 nm radiation from an argon ion laser, and to the 532 nm radiation from a frequency-doubled YAG laser, both of which are convenient sources for the production of holograms.

This preferred sensitizer also sensitizes ferrocenium salts to the same wavelengths, and has the advantage that it is photobleachable, so that the visible absorption of the holographic medium decreases during the exposure, thus helping to produce a low minimum optical density ($D_{min}$) in the hologram.

The proportions of acid generator, binder and monomers in the holographic recording medium of the present invention may vary rather widely, and the optimum proportions for specific components and methods of use can readily be determined empirically by skilled workers. However, in general, it is preferred that the present medium comprise from 0.2 to 5 parts by weight of the difunctional epoxide monomer per part by weight of the polyfunctional epoxide monomer, and it also preferred that the medium comprise from 0.16 to 5 parts by weight of the binder per total part by weight of the difunctional epoxide monomer and the polyfunctional epoxide monomer.

For reasons already explained above, it is desirable that the components of the holographic recording medium of the present invention be chosen so that the volume shrinkage of the medium be kept as small as possible; this shrinkage desirably does not exceed about 1 per cent.

The following Examples are now given, though by way of illustration only, to show details of particularly preferred reagents, conditions and techniques used in preferred media and processes of the present invention.

Example 1

A series of holographic recording media was prepared comprising (4-octyloxyphenyl)phenyliodonium hexafluoroantimonate (an acid generator), 5,12-*bis*-(phenylethynyl)naphthacene (hereinafter called "BPEN"; this material sensitizes the iodonium salt to green visible radiation), and, as a binder, poly(methyl phenyl siloxane), refractive index 1.5365, available from Dow Chemical Company, Midland, Michigan, United States of America, under the tradename Dow 710 silicone fluid. The media further comprised the difunctional epoxide monomer of Formula I above in which each group R is methyl, and either the tetrafunctional monomer 1,3,5,7-*tetrakis*(2-(3,4-epoxycyclohexyl)ethyl)-1,3,5,7-tetramethylcyclotetrasiloxane, or the trifunctional monomer of Formula III above in which $R^3$ is a methyl group; each group $R^4$ is a methyl group, and each group $R^5$ is a 2-(3,4-epoxycyclohexyl)ethyl grouping. The exact compositions of the media formulated, and the mole ratios of difunctional to polyfunctional monomer therein are set forth in Table 1 below.

Each holographic recording medium was prepared by first adding the specified weight of the difunctional epoxide to a sufficient amount of the iodonium salt to make the content of the iodonium salt in the final recording medium 4.8 percent by weight. Dissolution of the iodonium salt occurred upon stirring. The specified weight of the tri- or tetrafunctional monomer was then added and the mixture was stirred until a uniform mixture was obtained. The Dow 710 binder was added to the resultant mixture, and a uniform mixture was obtained after stirring. Finally, a sufficient amount of the BPEN sensitizer, dissolved in approximately 300 μL of methylene chloride, was added to the mixture to form a final mixture containing 0.048% by weight of the sensitizer. This final mixture was stirred and the methylene chloride removed by purging the medium with argon gas, to form the holographic recording medium, which had the form of a solution.

Table 1

| **Component** | **Weight (mg)** | | | |
|---|---|---|---|---|
| Difunctional monomer | 150 | 225 | 306 | 460 |
| Tetrafunctional monomer | - | - | 340 | 266 |
| Trifunctional monomer | 150 | 75 | - | - |
| Binder | 100 | 100 | 162 | 162 |
| Iodonium salt | 20 | 20 | 40 | 40 |
| Sensitizer | 0.2 | 0.2 | 0.4 | 0.4 |
| Mole ratio (di:poly) | 63:37 | 83:17 | 63:37 | 77:23 |

To test the holographic recording characteristics of these media, a sample of each medium was placed between two glass slides separated by a 100 μm polytetrafluoroethylene spacer. Unslanted, plane-wave, transmission holograms were recorded in the conventional manner with two spatially filtered and collimated argon ion laser writing beams at 514.5 nm with equal irradiance levels (± 2%) directed onto the sample with equal semiangles of 25° about the normal. Since these media are not sensitive to red light, a beam-expanded helium neon laser probe beam (λ = 632.8 nm), incident at the appropriate Bragg angle, was used to detect the development of holographic activity during exposure. Real time diffraction intensity data was obtained before, during and after holographic exposure using two model 818-SL photodiodes and a dual channel multi-function optical meter Model 2835-C from Newport Corporation. The zeroth order and first order diffraction intensities from the grating were measured, and the holographic efficiency determined.

Samples containing the tetrafunctional monomer were imaged with a total holographic exposure fluence of 93 $mJ/cm^2$, using two 5 second exposures separated by a wait time of 25 seconds. Threshold energies (defined as the fluence necessary for observation of a stable diffraction efficiency of about 0.1%), were approximately 18.9 and 20.5 $mJ/cm^2$ for the 77:23 and 63:37 mole ratio media, respectively. High diffraction efficiency was attained and the hologram was stable without post-imaging exposure.

Samples containing the trifunctional monomer were imaged with a holographic exposure fluence of either 75 $mJ/cm^2$ or 47 $mJ/cm^2$ (for the 83:17 medium) using a continuous 8 or 5 second exposure, and 75 $mJ/cm^2$ (for the 63:37 medium) using a continuous 8 second exposure. Threshold energies for the 83:17 and 63:37 mole ratio media were approximately 21 and 33 $mJ/cm^2$, respectively. High diffraction efficiency was attained and the hologram was stable without post-imaging exposure.

Example 2

A series of holographic recording media was prepared comprising the same acid generator, sensitizer, binder and difunctional epoxide monomer as in Example 1 above. However, the polyfunctional monomer used was the tetrafunctional monomer of Formula III above in which $R^3$ is an $OSi(CH_3)_2$-Z-(3,4-epoxycyclohexyl)ethyl grouping; each group $R^4$ is a methyl group, and each group $R^5$ is a 2-(3,4-epoxycyclohexyl)ethyl grouping. The exact compositions of the media formulated, and the mole ratios of difunctional to polyfunctional monomer therein are set forth in Table 2 below. The media were formulated in the same manner as in Example 1 above.

Table 2

| Component | Weight (mg) | | | | |
|---|---|---|---|---|---|
| Difunctional monomer | 321.3 | 460 | 306 | 192 | 197.6 |
| Tetrafunctional monomer | 132 | 297 | 360 | 412 | 833.7 |
| Binder | 114 | 190 | 167 | 152 | 260.8 |
| Iodonium salt | 28 | 47 | 41 | 38 | 67.5 |
| Sensitizer | 0.28 | 0.47 | 0.42 | 0.4 | 0.8 |
| Mole ratio (di:poly) | 84:16 | 77:23 | 64:36 | 50:50 | 33:67 |

The imaging properties of these media were tested in the same manner as in Example 1 above, using a fluence of 93.3 $mJ/cm^2$. Two different exposure schedules were used, namely a continuous 10 second exposure and two 5 second exposures separated by a 30 second wait period. The lowest threshold energies recorded under these conditions were 34.2, 30.1, 32.2, 17.4 and 26.1 $mJ/cm^2$ for the 84:16, 77:23, 64:36, 50:50 and 33:66 formulations respectively.

The threshold energy for the 64:36 medium was in fact lower than recorded above due to a misalignment of the HeNe probe beam. High diffraction efficiency was attained (circa 90%) for holograms recorded in media of each composition, and the holograms were stable without post-imaging exposure. A sample of the 50:50 mole ratio formulation with the contents of iodonium salt and sensitizer increased to 6.1% and 0.1%, respectively, exhibited a decrease in threshold energy to less than about 9 $mJ/cm^2$ and an increase in sensitivity by a factor of about 2.4.

Example 3

A holographic recording medium was prepared comprising the same acid generator, sensitizer, and difunctional epoxide monomer as in Example 1 above. The medium also comprised a polyfunctional epoxide monomer of Formula IV above, this monomer being of the formula:

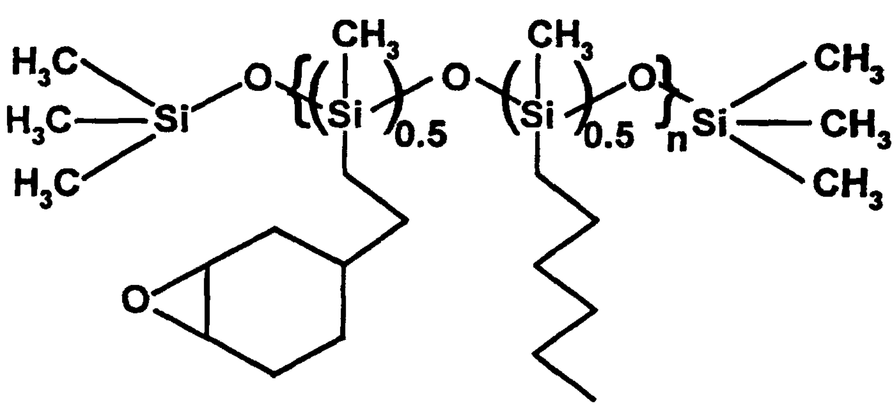

and, as a binder, 1,3,5-trimethyl-1,1,3,5,5-pentaphenyltrisiloxane (refractive index 1.579, available from Dow Chemical Company, Midland, Michigan, United States of America, under the tradename Dow 705 silicone fluid). The medium contained 4.6 weight percent of the iodonium salt, 0.09 weight percent of the sensitizer and the monomer to binder mole ratio (based upon segmental values for the polyfunctional monomer) was 2.78. The medium was prepared in the

same manner as in Example 1 above.

Samples of this medium were imaged in the same way as in Example 1 with a holographic exposure fluence of either 28 $mJ/cm^2$ or 18.7 $mJ/cm^2$ using a continuous 3 or 2 second exposure, respectively. Threshold energies were only about 1.5 $mJ/cm^2$ and the sensitivity was approximately four times as high as that of the media described in Example 2, for the same iodonium salt concentration. High diffraction efficiency was attained and the hologram was stable without post-imaging exposure.

Example 4

This Example illustrates the low shrinkage which can be achieved during imaging of holographic recording media of the present invention.

A holographic recording medium was prepared comprising the same difunctional epoxide monomer and sensitizer as in Example 1 above, and the tetrafunctional monomer of the formula:

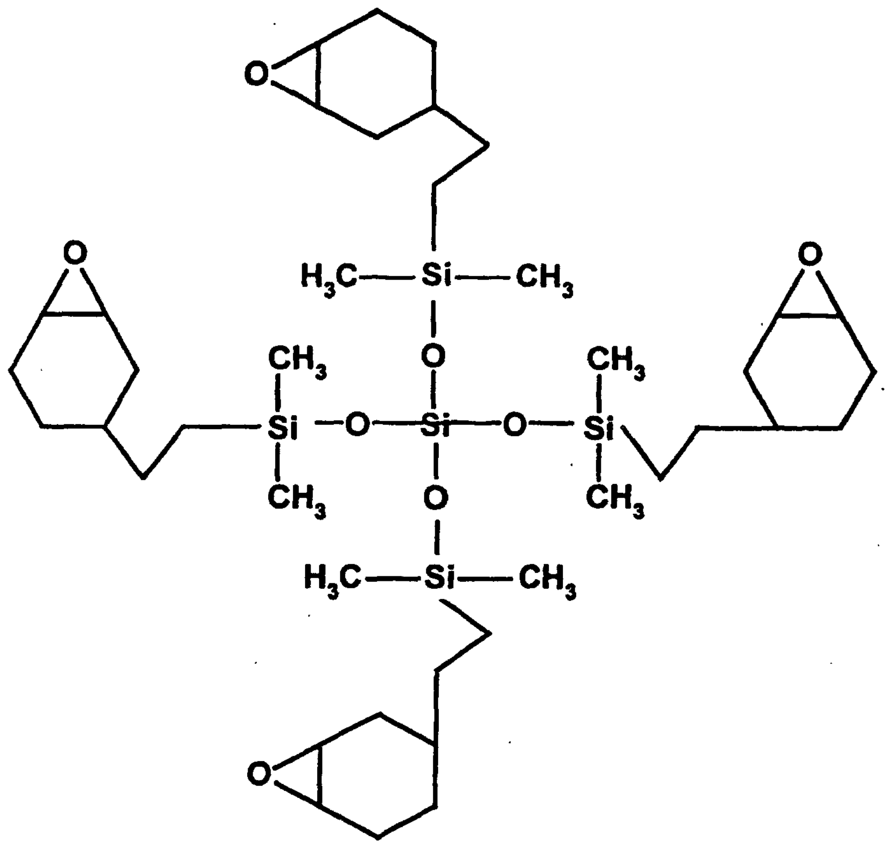

which falls within Formula III above. The ratio of epoxy groups in the difunctional and tetrafunctional monomers was 0.73. The binder used was the same as that in Example 3 above, and the equivalent monomer to binder segmental based weight ratio was 68.0:32.0. The iodonium salt used was *bis*(methylphenyl)iodonium *tetrakis*(pentafluorophenyl) borate (obtained from Rhone Poulenc as Silcolease UV Cata Poudre (Registered Trade Mark) 200 and purified by recrystallization from methylene chloride:hexane and dried before use). The holographic medium was prepared in the same manner as in Example 1 above and contained 7.0 weight percent of the iodonium salt, and 0.036 weight percent of the sensitizer.

Slant fringe plane-wave, transmission holograms were recorded with a frequency doubled Nd:YAG laser at 532 nm using two spatially filtered and collimated laser writing beams directed onto a sample of this medium with an interbeam angle of 34°10°. The intensities of the two beams were adjusted to compensate for relative angle cosine factors. The sample was mounted onto a motorized rotation stage, Model 495 from Newport Corporation. The rotational position of the stage, and thus the angle of the sample plane relative to the writing beams, was computer controlled via a motion controller Model PMC200P from Newport Corporation. Accordingly, during the holographic exposures the interbeam angle of the signal and reference beam paths remained fixed, while the sample of the holographic recording medium was rotated to alter the grating angle of the resultant slant fringe hologram.

Angular selectivity measurements were performed using spatially filtered and collimated laser reading beams from a frequency doubled Nd:YAG laser at 532 nm with incident power of about 20 μW. The sample was mounted on a motorized rotation stage, as during recording, and thus the angle of the sample plane relative to either the reference or signal beam was computer controlled via a motion controller Model PMC200P from Newport Corporation. The read angle was detuned from the recording state while maintaining the sample in its original mount position, and the diffraction efficiency was measured at each angular increment with photodiodes and an optical meter from Newport Corporation (see above). The angular resolution was 0.001° and the experimentally determined repeatability was ≤0.005°, which was attained by use of unidirectional rotation during measurement thereby eliminating any effect from backlash of the compliant worm gear. Accordingly, for these measurements the signal and reference beam paths remain fixed with an interbeam angle of 34° 10', while the surface plane of the volume hologram was rotated to alter the incident angle of the signal and reference read beam paths. Measurement of angular selectivity was carried out independently for the signal and reference beams, along beam paths 1-2' (Readout 2') and 2-1' (Readout 1'), respectively, by rotation of the hologram over a range of plus or minus several degrees from the recording position at increments of $0.001° \leq \Delta\theta \leq 0.02°$. In this manner, during reconstruction of the volume hologram, angular deviations from the recording condition necessary to achieve Bragg matching, $\Delta\Omega_1$, and $\Delta\Omega_2$ (see the accompanying drawing), were obtained explicitly for the signal and reference beams for each slant fringe construction.

The grating vector components along the transverse (*z*-axis) and lateral directions (*x*-axis), $K_{z,i}$ and $K_{x,i}$, respectively, at the initial state of recording, can be expressed in terms of the average refractive index, *n*, of the recording medium, and the external signal and reference write beam angles, $\Omega_{1ext}$ and $_{\Omega 2ext}$, respectively, used during holographic recording as

$$K_{z,i} = \frac{2\pi}{\lambda}\left(\sqrt{n^2 - \sin^2\Omega_{1_{ext}}} - \sqrt{n^2 - \sin^2\Omega_{2_{ext}}}\right) \qquad (1)$$

$$K_{x,i} = \frac{2\pi}{\lambda}\left(\sin\Omega_{1_{ext}} + \sin\Omega_{2_{ext}}\right) \qquad (2)$$

The incremental changes in the grating vector components along the transverse and lateral directions, $\Delta K_z$ and $\Delta K_x$, respectively, that arise due to shrinkage, can be expressed in terms of measurable quantities as

$$\Delta K_z = \frac{2\pi}{\lambda}\left(\frac{\sin\Omega_{2_{ext}}\cos\Omega_{2_{ext}}}{\sqrt{n^2 - \sin^2\Omega_{2_{ext}}}}\Delta\Omega_{2_{ext}} - \frac{\sin\Omega_{1_{ext}}\cos\Omega_{1_{ext}}}{\sqrt{n^2 - \sin^2\Omega_{1_{ext}}}}\Delta\Omega_{1_{ext}}\right) + \frac{2\pi}{\lambda}\left(\frac{\Delta n}{n}\right)\left(\frac{n^2}{\sqrt{n^2 - \sin^2\Omega_{1_{ext}}}} - \frac{n^2}{\sqrt{n^2 - \sin^2\Omega_{2_{ext}}}}\right) \qquad (3)$$

and

$$\Delta K_x = \frac{2\pi}{\lambda}\left(\cos\Omega_{1_{ext}}\Delta\Omega_{1_{ext}} + \cos\Omega_{2_{ext}}\Delta\Omega_{2_{ext}}\right) \qquad (4)$$

where $\Delta\Omega_{1ext}$ and $\Delta\Omega_{2ext}$ are the respective angular deviations from the Bragg matching condition of the two write beams, and $\Delta n$ is the change in refractive index that occurs during recording.

The change in internal slant angle, $\Delta\phi$, can be expressed in terms of the initial lateral and transverse grating components, $K_{x,i}$ and $K_{z,i}$ and the respective changes, $\Delta K_x$ and $\Delta K_z$, as

$$\Delta\phi_{slant} = \frac{\left(K_{x,i}\Delta K_z - K_{z,i}\Delta K_x\right)}{\left(K_{x,i}{}^2 + K_{z,i}{}^2\right)} \qquad (5)$$

where during shrinkage the grating period component, $\Lambda_x$, is not assumed to be fixed as the grating slant angle rotates to increased angle, contrary to the boundary conditions of the fringe rotation model. The relative changes in the transverse (perpendicular to film plane) and lateral (parallel to film plane) components of the grating vector, $-\Delta K_z/K_{z,i}$ and $-\Delta K_x/K_{x,i}$, respectively, are equal to the physical material shrinkage along the respective directions independent of slant angle, $\phi$. Referring to the accompanying drawing and assuming uniaxial shrinkage, the grating period in the transverse direction, $\Delta_z$, are before and after recording

$$\Lambda_{zj} = \frac{\Lambda_i}{\cos\phi} \qquad (6)$$

$$\Lambda_{zj} = \frac{\Lambda_i}{\cos\phi_j} \qquad (7)$$

where $K_z = 2\pi/\Lambda_z$ and $\Delta K_z/K_z = -\Delta\Lambda_z/\Lambda_z$. Generally, regardless of whether or not the shrinkage is uniaxial $\Delta K_x/K_x = -\Delta\Lambda_x/\Lambda_x$. Clearly $\Delta K/K_i$ varies, depending upon the slant angle, but, although the magnitude $\Delta K/K_i$ directly represents the amount of dimensional change along the grating vector direction, it does not provide directional information and contains no contribution from the lateral *y* direction. To assess the relative volume change, $\Delta V/V$, during recording requires an assumption of homogeneity in the lateral directions (i.e. $\Delta x/x = \Delta y/y$) which is reasonable for volume hologram formation in photopolymers, considering that the final recorded state is a glassy material. The relative volume shrinkage can thus be expressed as

$$\frac{\Delta V}{V} = -\left(\frac{\Delta K_z}{K_{z,i}} + \frac{2\Delta K_x}{K_{x,i}}\right) \qquad (8)$$

**1. Angular shifts**

The magnitude of dimensional change in the grating period along the x (lateral) and z (transverse) directions, $-\Delta K_x/K_{x,i}$ and $-\Delta K_z/K_{z,i}$, that occurs during hologram formation was calculated explicitly from the shift in the grating vector components using Equations. 3, 4, 6, and 7 above by (1) measuring the deviation of the Bragg angle from the external signal and reference beam write angles, $\Delta\Omega_{1ext}$ and $\Delta\Omega_{2ext}$, respectively; and (2) determining the change in the average refractive index, n, of the holographic recording medium. The former was obtained by directly measuring the differential angle changes in the reference and signal beam angles, necessary to achieve Bragg matching, by rotation of the sample (i.e. the recording geometry is not altered). The latter was measured to within $2 \times 10^{-4}$ using a Bausch & Lomb Refractometer. Since the bond order does not change during Cationic Ring Opening Polymerization, the increase in refractive index that results during exposure of the recording medium is due predominantly to densification of the material.

The results are presented in Tables 3 and 4 for slant fringe plane-wave holograms recorded to near saturation (diffraction efficiency 90%) in the recording medium of this Example. Counterclockwise rotations of the sample plane, for slant fringe holograms with internal grating angles of $\phi = 5°$, were required to Bragg match $\Omega_{1ext}$ and $\Omega_{2ext}$ immediately after recording. The differential angle changes, $\Delta\Omega_{1ext}$ and $\Delta\Omega_{2ext}$, were thus negative (-) and positive (+), respectively, regardless of whether the signal and reference beam recording angles are in the same or different quadrants. The requisite counterclockwise rotation increased slightly during the wait time necessary to attain stable plateau values. Accordingly the final signs of $\Delta\Omega_{1ext}$ and $\Delta\Omega_{2ext}$ for $\phi = 5°$ were (-) and (+), respectively, which indicates that the grating slant angle increased and the grating period decreased.

In Table 3 are listed measured values of $\Omega_{1ext}$, $\Omega_{2ext}$, $\Delta\Omega_{1ext}$, and $\Delta\Omega_{2ext}$ and the corresponding internal grating slant angles at the onset of recording, $\phi_o$, the initial state at which stable diffraction efficiency is first observed, $\phi_i$, and the final physical state of the holographic recording medium, $\phi_f$. The values of $\Delta\Omega_{1ext}$ and $\Delta\Omega_{2ext}$ listed are the final

shifts (plateau values) observed for individual holograms recorded with grating slant angle between about 0.03° and 30°. At the onset of recording the material is a fluid, whereas when stable grating formation first occurs the material is in a pre-gelatinous state, and after recording and achieving the full extent of cure the material is in a glassy state. Accordingly, the initial value of the refractive index, used in Table 3 and for calculations of $\Delta K_x/K_{x,i}$ and $\Delta K_z/K_{z,i}$ listed in Table 4, was ascertained from measurement of the recording medium after an imaging exposure equivalent to the requisite fluence for observation of stable diffraction efficiency (i.e. $\eta \sim 0.25\%$). The physical state of the recording medium after such an exposure comprises sufficient microstructural integrity to manifest a stable fringe structure with defined spatial frequency. This exposure exceeds the threshold exposure fluence, defined here as the fluence necessary to first detect holographic activity, by a few $mJ/cm^2$. For purposes of calculating the physical material shrinkage, $\Delta V/V$, this method provides a more equitable estimate of the initial refractive index during hologram formation, when recording to near saturation, than would values at the onset of recording. Use of the former will probably result in a conservative estimate of the physical material shrinkage, whereas employing the latter could effect a consequential underestimate of $\Delta K_z/K_{z,i}$ ($\Delta K_x/K_{x,i}$ is independent of $\Delta n$) if a significant change in refractive index occurs during early stages of hologram formation. The final value of the refractive index used in Tables 3 and 4 corresponds to that measured after the photopolymer recording medium was exposed with a non-holographic fluence commensurate with that needed to consume the entire dynamic range.

The magnitude of the angular deviations listed in Table 3 are about one fifth of that reported recently for a slant fringe hologram recorded with similar grating angle in a conventional photopolymer based on radical chemistry; see the aforementioned Rhee et al. paper. As noted above, modest levels of shrinkage, attributed to densification concurrent with photopolymerization, have typically caused angular deviations in the Bragg profile which can exceed the angular bandwidth, even for moderate slant angles. The angular shifts exhibited by the recording medium of this Example, however, are less than the angular bandwidths of the angular profiles for holograms with internal grating slant angles ≤ 30°, and with a thickness of about 130 µm. These results also indicate that when volume holograms are recorded with increasing grating slant angle then a concomitant increase is exhibited in their respective angular shifts from the Bragg matching condition. This increase is consistent with contributions to physical shrinkage that arise from the relation between increased slant angle and larger transverse components of the grating vector, as is apparent from Equation 5 above. The magnitude of the relative differences in angular shifts as a function of grating slant angle is an important performance criterion in considering holographic materials for applications such as optical data storage. For example, if the differences are large for a single image which comprises multiple gratings, such as for a Fourier image, then image reconstruction will display lack of image fidelity and consequently distortion, thereby impairing the achievable raw error bit rate.

Table 3

| Measured external angles and deviations of recording external angles from the Bragg matching condition, and calculated internal grating slant angles for plane-wave slant fringe holograms recorded to near saturation | | | | |
|---|---|---|---|---|
| Slant fringe holograms* | 5° | 10° | 20° | 30° |
| *External angles and Bragg shifts (degrees)* | | | | |
| $\Omega_{1ext}$ † | 8.1 | 0.0 | -15.0 | - 34.0 |
| $\Omega_{2ext}$ † | 23.9 | 34.05 | 49.05 | 68.05 |
| $\Delta\Omega_{1ext}$ ‡ | - 0.21 | - 0.23 | - 0.38 | - 0.70 |
| $\Delta\Omega_{2ext}$ ‡ | + 0.175 | + 0.28 | + 0.60 | + 1.50 |
| *Grating slant angles, ø (degrees)* | | | | |
| $\phi_o$§ | 5.093 | 10.858 | 19.894 | 29.743 |
| $\phi_i$ ‖ | 5.068 | 10.803 | 19.791 | 29.582 |
| $\phi_f$ ¶ | 5.156 | 10.886 | 19.922 | 29.793 |

* Slant fringe holograms were recorded to near saturation with internal slant angles, $\phi$, of about 5°, 10°, 20°, and 30°.

†$\Omega_{1ext}$ and $\Omega_{2ext}$ are the external signal and reference recording angles, respectively. The external interbeam angle for $\phi$ =5° was 32.0°, and for $\phi \geq 10°$ it was 34.05°.

‡$\Delta\Omega_{1ext}$ and $\Delta\Omega_{2ext}$ are the deviations of the external signal and reference beam read angles from the Bragg matching condition.

**§** $\phi_o$, is the internal slant angle at onset of recording where $n_{0,532}$ = 1.5133

‖ $\phi_i$ is the internal slant angle when stable diffraction efficiency is first observed, where $n_{i,532}$ = 1.5206.

¶ $\phi_f$ is the final internal slant angle after photopolymer is fully cured and is calculated by adding $\Delta\Omega_{1ext}$ to $\Omega_{1ext}$ and $\Delta\Omega_{2ext}$ to $\Omega_{2ext}$ and then determining the slant angle using $n_{f,532}$ = 1.5305.

Table 3 (continued)

| Measured external angles and deviations of recording external angles from the Bragg matching condition, and calculated internal grating slant angles for plane-wave slant fringe holograms recorded to near saturation | | | | |
|---|---|---|---|---|
| Slant fringe holograms* | 5° | 10° | 20° | 30° |
| *Grating slant angles, ø (degrees)* | | | | |
| $\phi_f$ ** | 5.157 | 10.887 | 19.923 | 29.802 |

* Slant fringe holograms were recorded to near saturation with internal slant angles, $\phi$, of about 5°, 10°, 20°, and 30°.

** $\phi_f$ is the final internal slant angle after photopolymer is fully cured and is calculated by taking the first order approximation of $\Delta\phi$ (as a function of $\Omega_{1ext}$, $\Omega_{2ext}$, $\Delta\Omega_{1ext}$, $\Delta\Omega_{2ext}$, and $\Delta n = n_f - n_i$ ) and then adding $\Delta\phi$ to $\phi$ (see Equation 5 above).

**2. Grating vector components**

In Table 4 are listed calculated values of $\Delta K_x/K_x$ and $\Delta K_z/K_z$, which are equal to the negative of the relative changes in grating period in the lateral and transverse directions, $-\Delta\Lambda_x/\Lambda_x$ and $-\Delta\Lambda_z/\Lambda_z$, respectively, for holograms recorded to near saturation with a range of grating slant angles between about 5° and 30°. The magnitude of the physical material shrinkage along the transverse direction was on the order of 0.8% for internal grating slant angle $\phi \geq 10°$, and similarly the average volume change was about 0.8 %. This is in close agreement with the increase in refractive index, $\Delta n$ = 0.65%, that is exhibited by the recording medium during formation of holograms with high diffraction efficiency, and is less than the total increase of 1.14% ($\Delta n_{532}$ = +0.0172) between the fluid state and the fully polymerized glass state. Cationic ring opening polymerization is not accompanied by a change in bond order, and thus the increase in refractive index that occurs during polymerization is directly related to densification of the recording material. For $\phi$ = 5° the magnitude of shrinkage along the transverse direction was enlarged to 1.61 % whereas the volume shrinkage, 1.31%, was slightly lower than the transverse value due to a small positive dimensional change in the lateral direction. The magnitude of $\Delta\Lambda_x$ is close to zero, and consequently a slight swelling in the lateral direction would be manifested as an overall expansion of $\Lambda_x$, whereas the magnitude of $\Delta\Lambda_z$ is about 10 times greater and thus largely unaffected.

The changes in internal slant angle are also listed in Table 4, as determined by using the aforementioned methods for measuring differential angle changes and refractive indices. The increases in grating slant angle occurring during hologram formation were small, and although the magnitude increased in monotonic fashion with larger slant angles for $\phi$ > 5° the percentage change was less than 1%. Near unslanted plane-wave holograms (e.g. $\phi$ = -0.03°) exhibited extremely small angular deviations, $\Delta\Omega_{1ext}$ = -0.03° and $\Delta\Omega_{2ext}$ = 0.003°, from the Bragg matching condition, indicating that negligible dimensional change occurred along the lateral direction under these recording conditions. The error associated with determining the physical volume change from relative changes in the components of the grating vector is, however, quite large for cases when the slant angle is less than about 3°. At small slant angles the values of $K_z$i, which are fractional and about of factor of 10 smaller than $\phi$, dominate determination of $\Delta K_z/K_z$,i. Consequently, even small errors in $\phi$, and thus $\Omega_{1ext}$ and $\Omega_{2ext}$, have a significant effect on the magnitude of $\Delta K_z/K_z$,i, as is apparent from Equations 3 and 4 above. Experimental errors in $\Delta\Omega_{1ext}$ and $\Delta\Omega_{2ext}$ are thus amplified for small grating slant angles, and in such cases contribute to large uncertainties in the final calculated value of the change in physical volume.

Values of $\Delta K_x/K_{x,i}$, $\Delta K_z/K_{z,i}$, and $\Delta V/V$, determined using Equations 1 and 2 above for an exact solution by adding $\Delta\Omega_{1ext}$ to $\Omega_{1ext}$, $\Delta\Omega_{2ext}$ to $\Omega_{2ext}$, and $\Delta n$ to $n$, to obtain $K_x$ and $K_z$ after recording, are also listed in Table 4. Results from the first order approximation, obtained using Equations 3 and 4 above, agree closely with results of the exact solution for holograms recorded with grating slant angles of ≤ 20°. The first order approximation, however, effects an overestimate for the magnitude of shrinkage along the transverse direction when the internal grating slant angle $\phi \cong 30°$. Although the shrinkage is low the size of the Bragg mismatch for $\phi \cong 30°$ is sufficiently large to cause the difference noted. The data given in Tables 3 and 4 establish that volume holograms recorded with increasingly larger grating slant angles, and which undergo essentially equal amounts of shrinkage in the transverse direction during hologram formation, exhibit a concomitant increase in their respective angular shifts from the Bragg matching condition. Accordingly, if the amount of shrinkage is small, then the first order approximation method provides a satisfactory method for determining shrinkage, except for cases involving large grating slant angles where the Bragg mismatch may be large. Conversely, if the amount of shrinkage is moderate (i.e. several percent or larger) then the magnitude of the Bragg mismatch is necessarily large, even for small grating angles, and thus the exact solution method should be applied, except over a narrow range of small grating angles.

Table 4

| Calculated relative changes in the grating vector along the transverse and lateral directions, and the relative material volume change with the assumption of homogeneity in the lateral directions, for plane-wave slant fringe holograms recorded to near saturation | | | | |
|---|---|---|---|---|
| Slant fringe holograms | 5° | 10° | 20° | 30° |
| *First order solution* | | | | |
| $\Delta\phi$ (o)† | 0.089 | 0.484 | 0.133 | 0.221 |
| $\Delta K_z/K_{z,i}$ (%)‡ | 1.613 | 0.801 | 0.818 | 0.804 |
| $\Delta K_x/K_{x,i}$ (%) ‡ | -0.153 | 0.006 | 0.092 | - 0.093 |
| $-\Delta V/V$ (%)§ | 1.307 | 0.813 | 1.002 | 0.617 |
| *Direct solution* | | | | |
| $\Delta\phi$ (°)‖ | 0.088 | 0.083 | 0.131 | 0.211 |
| $\|\Delta K_z/K_{z,i}$ (%)¶ | 1.598 | 0.793 | 0.802 | 0.690 |
| $\|\Delta K_x/K_{x,i}$ (%)¶ | - 0.154 | 0.005 | 0.085 | - 0.168 |
| $\|-\Delta V/V$ (%)** | 1.291 | 0.803 | 0.972 | 0.353 |

† $\Delta\phi$ is determined by taking the first order approximation (see Equation 5 above) where components of K and $\Delta K$ in lateral and transverse directions are defined in Equations 1, 2, 3, and 4, and $\Delta n = n_{f,532} = n_{f,532}$ as in Table 3.

‡ $\Delta K_z/K_{z,i}$ and $\Delta K_x/K_{x,i}$ are the relative changes in the grating vecto components along the transverse and lateral directions (equals th negative of the material shrinkage, $-\Delta\Lambda_z/\Lambda_z$ and $-\Delta\Lambda_x/\Lambda_x$, in the *z* an *x* directions, independent of slant angle) and are calculated using th first order approximation from Equations 3 and 4.

§ $-\Delta V/V$ is determined using Equation 8 and the first order approximation for $\Delta K_z/K_{z,i}$ and $\Delta K_x/K_{x,i}$ and assuming that dimensional changes in x and y are equal.

## Claims

1. A process for preparing a volume hologram, which process comprises:

   providing a volume holographic recording medium comprising an acid generator capable of producing an acid upon exposure to actinic radiation; a binder; and a material capable of undergoing cationic polymerization initiated by the acid produced from the acid generator; and
   passing into the medium a reference beam of coherent actinic radiation to which the acid generator is sensitive and an object beam of the same coherent actinic radiation; thereby forming within the medium an interference pattern and thereby forming a volume hologram within the medium.

   **characterized in that** the material capable of undergoing cationic polymerization comprises a difunctional epoxide monomer or oligomer; and a polyfunctional epoxide monomer or oligomer.

2. A process according to claim 1 **characterized in that** at least one of the difunctional epoxide monomer or oligomer and the polyfunctional epoxide monomer or oligomer comprises a siloxane and/or a cycloalkene oxide.

3. A process according to claim 2 **characterized in that** the difunctional epoxide monomer is of the formula:

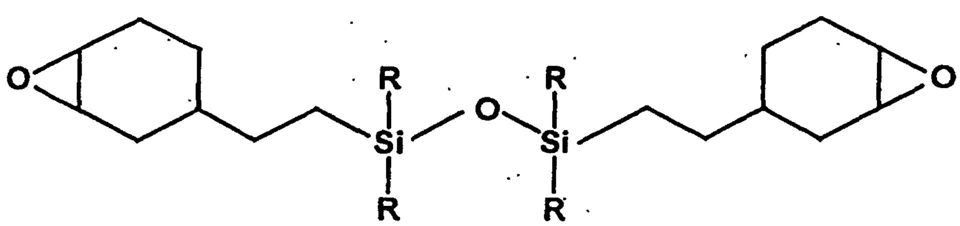

(I)

wherein each R independently is an alkyl or cycloalkyl group.

**4.** A process according to any one of the preceding claims **characterized in that** the polyfunctional epoxide monomer comprises one of more materials of the following formulae:

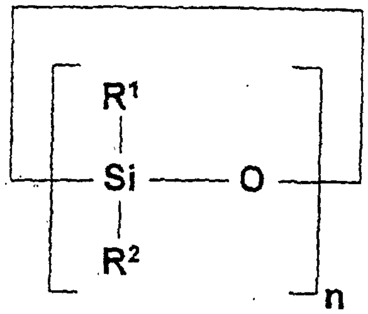

(II)

wherein each group $R^1$ is, independently, a monovalent substituted or unsubstituted $C_{1-12}$ alkyl, $C_{1-12}$ cycloalkyl, aralkyl or aryl group; each group $R^2$ is, independently, $R^1$ or a monovalent epoxy functional group having 2-10 carbon atoms, with the proviso that at least three of the groups $R^2$ are epoxy functional; and n is from 3-10;

$$R^3\ Si(OSi(R^4)_2R^5)_3 \qquad (III)$$

wherein $R^3$ is an $OSi(R^4)_2R^5$ grouping, or a monovalent substituted or unsubstituted $C_{1-12}$ alkyl, $C_{1-12}$ cycloalkyl, or aryl group; each group $R^4$ is, independently, a monovalent substituted or unsubstituted $C_{1-12}$ alkyl, $C_{1-12}$ cycloalkyl, aralkyl or aryl group; and each group $R^5$ is, independently, a monovalent epoxy functional group having 2-10 carbon atoms; and

$$(R^6)_3SiO[SiR^7R^8O]_p[Si(R^7)_2O]_qSi(R^6)_3 \qquad (IV)$$

wherein each group $R^6$ is, independently, a monovalent substituted or unsubstituted $C_{1-12}$ alkyl, $C_{1-12}$ cycloalkyl, aralkyl or aryl group; each group $R^7$ is, independently, a monovalent substituted or unsubstituted $C_{1-12}$ alkyl, $C_{1-12}$ cycloalkyl, aralkyl or aryl group; each group $R^8$ is, independently, a monovalent epoxy functional group having 2-10 carbon atoms, and p is an integer equal to or greater than 3 and q is integer.

**5.** A process according to claim 4 wherein the polyfunctional epoxide monomer comprises one or more of :

(a) 1,3,5,7-tetrakis(2-(3,4-epoxycyclohexyl)ethyl)-1,3,5,7-tetramethylcyclotetrasiloxane;
(b) a compound of Formula (III) wherein $R^3$ is a methyl group or an $OSi(R^4)_2R^5$ grouping; each group $R^4$ is a methyl group, and each group $R^5$ is a 2-(3,4-epoxycyclohexyl)ethyl grouping;
(c) a compound of Formula (IV) wherein each group $R^6$ and $R^7$ is an alkyl group; and
(d) a compound of Formula (IV) wherein each group $R^8$ is an 2-(3,4-epoxycyclohexyl)ethyl grouping and *p* and *q* are approximately equal.

**6.** A process according to any one of the preceding claims **characterized in that** the holographic medium comprises from 0.2 to 5 parts by weight of the difunctional epoxide monomer or oligomer per part by weight of the polyfunctional epoxide monomer or oligomer.

**7.** A process according to any one of the preceding claims **characterized in that** the holographic medium comprises from 0.16 to 5 parts by weight of the binder per total part by weight of the difunctional epoxide monomer or oligomer and the polyfunctional epoxide monomer or oligomer.

**8.** A process according to any one of the preceding claims **characterized in that** the volume shrinkage of the holographic medium during the formation of the hologram does not exceed 1 per cent.

**9.** A volume holographic recording medium comprising an acid generator capable of producing an acid upon exposure to actinic radiation; a binder; and a material capable of undergoing cationic polymerization initiated by the acid

produced from the acid generator, **characterized in that** the material capable of undergoing cationic polymerization comprises a difunctional epoxide monomer or oligomer; and a polyfunctional epoxide monomer or oligomer, and said binder does not inhibit cationic polymerization of said difunctional and polyfunctional monomers or oligomers and the refractive index of said binder is significantly different from that of the polymerised difunctional and polyfunctional monomers or oligomers

**10.** A volume holographic recording medium according to claim 9 **characterized in that** the difunctional epoxide monomer or oligomer and the polyfunctional epoxide monomer or oligomer are as defined in any one of claims 2 to 5.

**11.** A volume holographic recording medium according to 9 or 10 **characterized in that** it comprises from 0.2 to 5 parts by weight of the difunctional epoxide monomer or oligomer per part by weight of the polyfunctional epoxide monomer or oligomer.

**12.** A volume holographic recording medium according to any one of claims 9 to 11 **characterized in that** it comprises from 0.16 to 5 parts by weight of the binder per total part by weight of the difunctional epoxide monomer or oligomer and the polyfunctional epoxide monomer or oligomer.

**13.** A volume holographic recording medium according to any one of claims 9 to 12 wherein said binder is a polysiloxane or a polystyrene.

**Patentansprüche**

**1.** Verfahren zur Erzeugung eines Volumen-Hologramms, welches [Verfahren] umfasst:

Bereitstellung eines volumen-holographischen Aufzeichnungsmediums, enthaltend einen Säurebildner, der in der Lage ist, bei der Belichtung mit aktinischer Strahlung eine Säure zu bilden; ein Bindemittel; und ein Material, das zu einer kationischen Polymerisation, die durch die aus dem Säurebildner erzeugten Säure initiiert wird, befähigt ist; und

Einführung eines Referenzstrahls mit kohärenter aktinischer Strahlung, gegenüber der der Säurebildner empfindlich ist, und eines Objektstrahls aus derselben kohärenten aktinischen Strahlung, in das Medium, wodurch im Medium ein Interferenzmuster gebildet und so im Medium ein Volumen-Hologramm erzeugt wird,

**dadurch gekennzeichnet, dass** das zu einer kationischen Polymerisation befähigte Material ein difunktionelles Epoxid-Monomer oder -Oligomer und ein polyfunktionelles Epoxid-Monomer oder -Oligomer enthält.

**2.** Verfahren nach Anspruch 1, **dadurch gekennzeichnet, dass** entweder das difunktionelle Epoxid-Monomer oder -Oligomer oder das polyfunktionelle Epoxid-Monomer oder -Oligomer, oder beide, ein Siloxan und/oder ein Cycloalkylenoxid enthält (enthalten).

**3.** Verfahren nach Anspruch 2, **dadurch gekennzeichnet, dass** das difunktionelle Epoxid-Monomer die Formel:

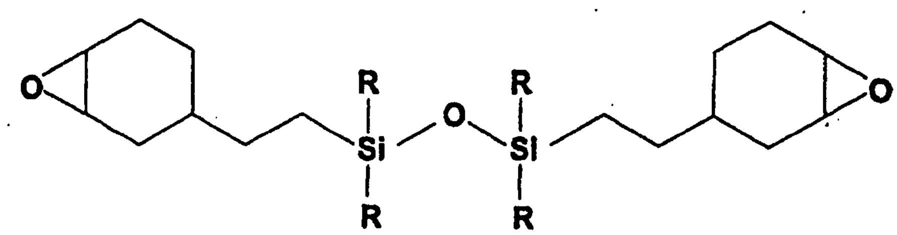

(I)

hat, worin jedes R unabhängig eine Alkyl- oder Cycloalkylgruppe darstellt.

**4.** Verfahren nach einem der vorhergehenden Ansprüche, **dadurch gekennzeichnet, dass** das polyfunktionelle Epoxid-Monomer ein oder mehrere Materialien der folgenden Formeln enthält:

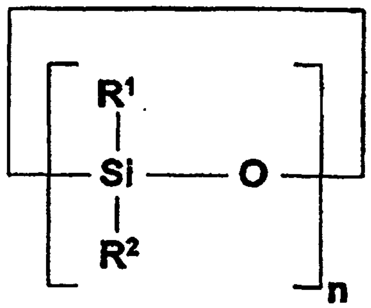

(II)

worin jede Gruppe $R^1$ unabhängig eine einwertige substituierte oder unsubstituierte $C_{1-12}$-Alkylgruppe, $C_{1-12}$-Cycloalkylgruppe, eine Aralkyl- oder Arylgruppe; jede Gruppe $R^2$ unabhängig $R^1$ oder eine einwertige epoxifunktionelle Gruppe mit 2 bis 10 Kohlenstoffatomen darstellt, mit der Maßgabe, dass mindestens drei der Gruppen $R^2$ epoxifunktionell sind; und n = 3 bis 10 bedeuten;

$$R^3Si(OSi(R^4)_2R^5)_3 \quad (III)$$

worin $R^3$ eine $OSi(R^4)_2R^5$-Gruppierung oder eine einwertige substituierte oder unsubstituierte $C_{1-12}$-Alkylgruppe, eine $C_{1-12}$-Cycloalkylgruppe, oder eine Arylgruppe; jede Gruppe $R^4$ unabhängig eine einwertige substituierte oder unsubstituierte $C_{1-12}$-Alkylgruppe, eine $C_{1-12}$-Cycloalkylgruppe, eine Aralkyl- oder eine Arylgruppe; und jede Gruppe $R^5$ unabhängig eine einwertige epoxifunktionelle Gruppe mit 2 bis 10 Kohlenstoffatomen bedeuten; und

$$(R^6)_3SiO[SiR^7R^8O]p[Si(R^7)_2O]_qSi\ (R^6)_3 \quad (IV)$$

worin jede Gruppe $R^6$ unabhängig eine einwertige substituierte oder unsubstituierte $C_{1-12}$-Alkylgruppe, eine $C_{1-12}$-Cycloalkylgruppe, eine Aralkyl- oder Arylgruppe; jede Gruppe $R^7$ unabhängig eine einwertige substituierte oder unsubstituierte $C_{1-12}$-Alkylgruppe, eine $C_{1-12}$-Cycloalkylgruppe, eine Aralkyl- oder Arylgruppe; jede Gruppe $R^8$ unabhängig eine einwertige epoxifunktionelle Gruppe mit 2 bis 10 Kohlenstoffatomen und p eine ganze Zahl von gleich oder größer als 3 und q eine ganze Zahl bedeuten.

**5.** Verfahren nach Anspruch 4, worin das polyfunktionelle Epoxid-Monomer eine oder mehrere [der Verbindungen] enthält:

(a) 1,3,5,7-Tetrakis(2-(3,4-epoxicyclohexyl)ethyl)-1,3,5,7-tetramethylcyclotetrasiloxan;

(b) eine Verbindung der Formel (III), worin $R^3$ eine Methylgruppe oder eine $OSi(R^4)_2R^5$-Gruppierung; jede Gruppe $R^4$ eine Methylgruppe und jede Gruppe $R^5$ eine 2-(3,4-Epoxicyclohexyl)ethyl-Gruppierung darstellt;

(c) eine Verbindung der Formel (IV), worin jede Gruppe $R^6$ und $R^7$ eine Alkylgruppe darstellt; und

(d) eine Verbindung der Formel (IV), worin jede Gruppe $R^8$ eine 2-(3,4-Epoxicyclohexyl)ethyl-Gruppierung darstellt, und p und q etwa gleich sind.

**6.** Verfahren nach einem der vorhergehenden Ansprüche, **dadurch gekennzeichnet, dass** das holographische Medium 0,2 bis 5 Gew.-Teile difunktionelles Epoxid-Monomer oder -Oligomer je Gew.-Teil des polyfunktionellen Epoxid-Monomers oder -Oligomers enthält.

**7.** Verfahren nach einem der vorhergehenden Ansprüche, **dadurch gekennzeichnet, dass** das holographische Medium 0,16 bis 5 Gew.-Teile Bindemittel auf die gesamten Gew.-Teile an difunktionellem Epoxid-Monomer oder -Oligomer und dem polyfunktionellen Epoxid-Monomer oder -Oligomer enthält.

**8.** Verfahren nach einem der vorhergehenden Ansprüche, **dadurch gekennzeichnet, dass** die Volumenschrumpfung des holographischen Mediums während der Bildung des Hologramms 1% nicht überschreitet.

9. Volumen-holographisches Aufzeichnungsmedium, enthaltend einen Säurebildner, der in der Lage ist, bei Belichtung mit aktinischer Strahlung eine Säure zu bilden; ein Bindemittel; und ein Material, das zu einer kationischen Polymerisation, die durch die aus dem Säurebildner erzeugte Säure initiiert wird, befähigt ist, **dadurch gekennzeichnet, dass** das zur kationischen Polymerisation befähigte Material ein difunktionelles Epoxid-Monomer oder -Oligomer; und ein polyfunktionelles Epoxid-Monomer oder -Oligomer enthält; und dass das Bindemittel die kationische Polymerisation der difunktionellen und polyfunktionellen Monomeren oder Oligomeren nicht behindert, und der Brechungsindex des Bindemittels sich deutlich von dem der polymerisierten difunktionellen und polyfunktionellen Monomere oder Oligomere unterscheidet.

10. Volumen-holographisches Aufzeichnungsmedium nach Anspruch 9, **dadurch gekennzeichnet, dass** das difunktionelle Epoxid-Monomer oder -Oligomer und das polyfunktionelle Epoxid-Monomer oder -Oligomer wie in einem der Ansprüche 2 bis 5 definiert sind.

11. Volumen-holographisches Aufzeichnungsmedium nach [Anspruch] 9 oder 10, **dadurch gekennzeichnet, dass** es 0,2 bis 5 Gew.-Teile difunktionelles Epoxid-Monomer oder -Oligomer je Gew.-Teil des polyfunktionellen Epoxid-Monomers oder -Oligomers enthält.

12. Volumen-holographisches Aufzeichnungsmedium nach einem der Ansprüche 9 bis 11, **dadurch gekennzeichnet, dass** es 0,16 bis 5 Gew.-Teile Bindemittel auf die gesamten Gew.-Teile an difunktionellem Epoxid-Monomer oder -Oligomer und dem polyfunktionellen Epoxid-Monomer oder -Oligomer enthält.

13. Volumen-holographisches Aufzeichnungsmaterial nach einem der Ansprüche 9 bis 12, worin das Bindemittel ein Polysiloxan oder ein Polystyrol darstellt.

## Revendications

1. Procédé de préparation d'un hologramme en volume, lequel procédé comporte :

   le fait de prendre un support d'enregistrement d'hologramme en volume qui contient un formateur d'acide capable de produire un acide à la suite d'une exposition à un rayonnement actinique, un liant, et un matériau capable de subir une polymérisation par voie cationique, amorcée par l'acide produit par le formateur d'acide ; et le fait de faire passer dans le support un faisceau référence de rayonnement actinique cohérent auquel est sensible le formateur d'acide et un faisceau objet du même rayonnement actinique cohérent ; ce qui permet de former un motif d'interférences au sein du support, et par là, de former un hologramme en volume au sein du support,

   **caractérisé en ce que** le matériau capable de subir une polymérisation par voie cationique comprend un époxyde difonctionnel monomère, ou oligomère et un époxyde polyfonctionnel monomère ou oligomère.

2. Procédé conforme à la revendication 1, **caractérisé en ce qu'**au moins l'un de l'époxyde difonctionnel monomère ou oligomère et de l'époxy- de polyfonctionnel monomère ou oligomère comprend un siloxane et/ou un oxyde de cycloalcène.

3. Procédé conforme à la revendication 2, **caractérisé en ce que** l'époxyde difonctionnel monomère a pour formule :

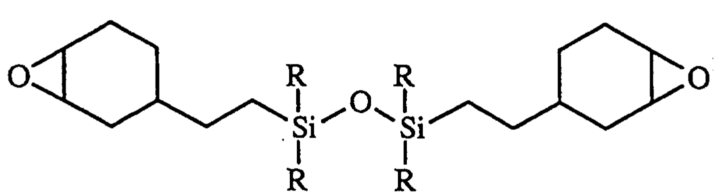

(I)

dans laquelle chaque R représente indépendamment un groupe alkyle ou cycloalkyle.

4. Procédé conforme à l'une des revendications précédentes, **caractérisé en ce que** l'époxyde polyfonctionnel monomère comprend un ou plusieurs composés ayant pour formule l'une des suivantes :

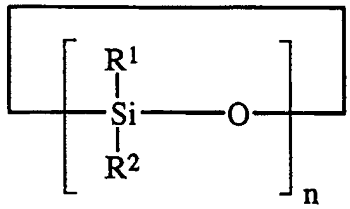

(II)

dans laquelle chaque $R^1$ représente indépendamment un groupe monovalent, substitué ou non, alkyle en $C_{1-12}$, cycloalkyle en $C_{1-12}$, aralkyle ou aryle, chaque $R^2$ représente indépendamment l'un des groupes indiqués pour R' ou un groupe monovalent à fonction époxyde et comportant de 2 à 10 atomes de carbone, sous réserve qu'au moins trois symboles $R^2$ représentent des groupes à fonction époxyde, et n vaut de 3 à 10 ;

$$R^3Si(OSi(R^4)_2R^5)_3 \qquad (III)$$

dans laquelle $R^3$ représente un groupe de formule $OSi(R^4)_2R^5$ ou un groupe monovalent, substitué ou non, alkyle en $C_{1-12}$, cycloalkyle en $C_{1-12}$, aralkyle ou aryle, chaque $R^4$ représente indépendamment un groupe monovalent, substitué ou non, alkyle en $C_{1-12}$, cycloalkyle en $C_{1-12}$, aralkyle ou aryle, et chaque $R^5$ représente indépendamment un groupe monovalent à fonction époxyde et comportant de 2 à 10 atomes de carbone ;

$$(R^6)_3SiO[SiR^7R^8O]_p[(Si(R^7)_2O)]_qSi(R^6)_3 \qquad (IV)$$

dans laquelle chaque $R^6$ représente indépendamment un groupe monovalent, substitué ou non, alkyle en $C_{1-12}$, cycloalkyle en $C_{1-12}$, aralkyle ou aryle, chaque $R^7$ représente indépendamment un groupe monovalent, substitué ou non, alkyle en $C_{1-12}$, cycloalkyle en $C_{1-12}$, aralkyle ou aryle, chaque $R^8$ représente indépendamment un groupe monovalent à fonction époxyde et comportant de 2 à 10 atomes de carbone, p représente un nombre entier qui est égal ou supérieur à 3, et q représente un nombre entier.

**5.** Procédé conforme à la revendication 4, dans lequel l'époxyde polyfonctionnel monomère comprend un ou plusieurs des composés suivants :

a) 1,3,5,7-tétrakis(2-(3,4-époxycyclohexyl)éthyl)-1,3,5,7-tétraméthylcyclotétrasiloxane ;
b) un composé de formule (III) dans laquelle $R^3$ représente un groupe méthyle ou un groupe de formule $OSi(R^4)_2R^5$, chaque $R^4$ représente un groupe méthyle et chaque $R^5$ représente un groupe 2-(3,4-époxycyclohexyl) éthyle ;
c) un composé de formule (IV) dans laquelle chaque symbole $R^6$ ou $R^7$ représente un groupe alkyle;
d) et un composé de formule (IV) dans laquelle chaque $R^8$ représente un groupe 2-(3,4-époxycyclohexyl) éthyle, et p et q représentent des nombres à peu près égaux.

**6.** Procédé conforme à l'une des revendications précédentes, **caractérisé en ce que** le support holographique contient de 0,2 à 5 parties en poids d'époxyde difonctionnel monomère ou oligomère pour 1 partie en poids d'époxyde polyfonctionnel monomère ou oligomère.

**7.** Procédé conforme à l'une des revendications précédentes, **caractérisé en ce que** le support holographique contient de 0,16 à 5 parties en poids de liant pour 1 partie en poids de la quantité totale d'époxyde difonctionnel monomère ou oligomère et d'époxyde polyfonctionnel monomère ou oligomère.

**8.** Procédé conforme à l'une des revendications précédentes, **caractérisé en ce que** le retrait volumique du support holographique au cours de la formation de l'hologramme ne dépasse pas 1 %.

**9.** Support d'enregistrement d'hologramme en volume, qui contient un formateur d'acide capable de produire un acide à la suite d'une exposition à un rayonnement actinique, un liant, et un matériau capable de subir une polymérisation par voie cationique, amorcée par l'acide produit par le formateur d'acide, **caractérisé :**

- **en ce que** le matériau capable de subir une polymérisation par voie cationique comprend un époxyde difonctionnel monomère ou oligomère et un époxyde polyfonctionnel monomère ou oligomère,
- et **en ce que** le liant n'inhibe pas la polymérisation par voie cationique desdits monomères et oligomères difonctionnels ou polyfonctionnels, et l'indice de réfraction du liant est significativement différent de celui des polymères formés à partir desdits monomères et oligomères difonctionnels ou polyfonctionnels.

**10.** Support d'enregistrement d'hologramme en volume, conforme à la revendication 9, **caractérisé en ce que** l'époxyde difonctionnel monomère ou oligomère et l'époxyde polyfonctionnel monomère ou oligomère sont tels que définis dans l'une des revendications 2 à 5.

**11.** Support d'enregistrement d'hologramme en volume, conforme à la revendication 9 ou 10, **caractérisé en ce qu'**il contient de 0,2 à 5 parties en poids d'époxyde difonctionnel monomère ou oligomère pour 1 partie en poids d'époxyde polyfonctionnel monomère ou oligomère.

**12.** Support d'enregistrement d'hologramme en volume, conforme à l'une des revendications 9 à 11, **caractérisé en ce qu'**il contient de 0,16 à 5 parties en poids de liant pour 1 partie en poids de la quantité totale d'époxy- de difonctionnel monomère ou oligomère et d'époxyde polyfonctionnel monomère ou oligomère.

**13.** Support d'enregistrement d'hologramme en volume, conforme à l'une des revendications 9 à 12, dans lequel le liant est un polysiloxane ou un polystyrène.

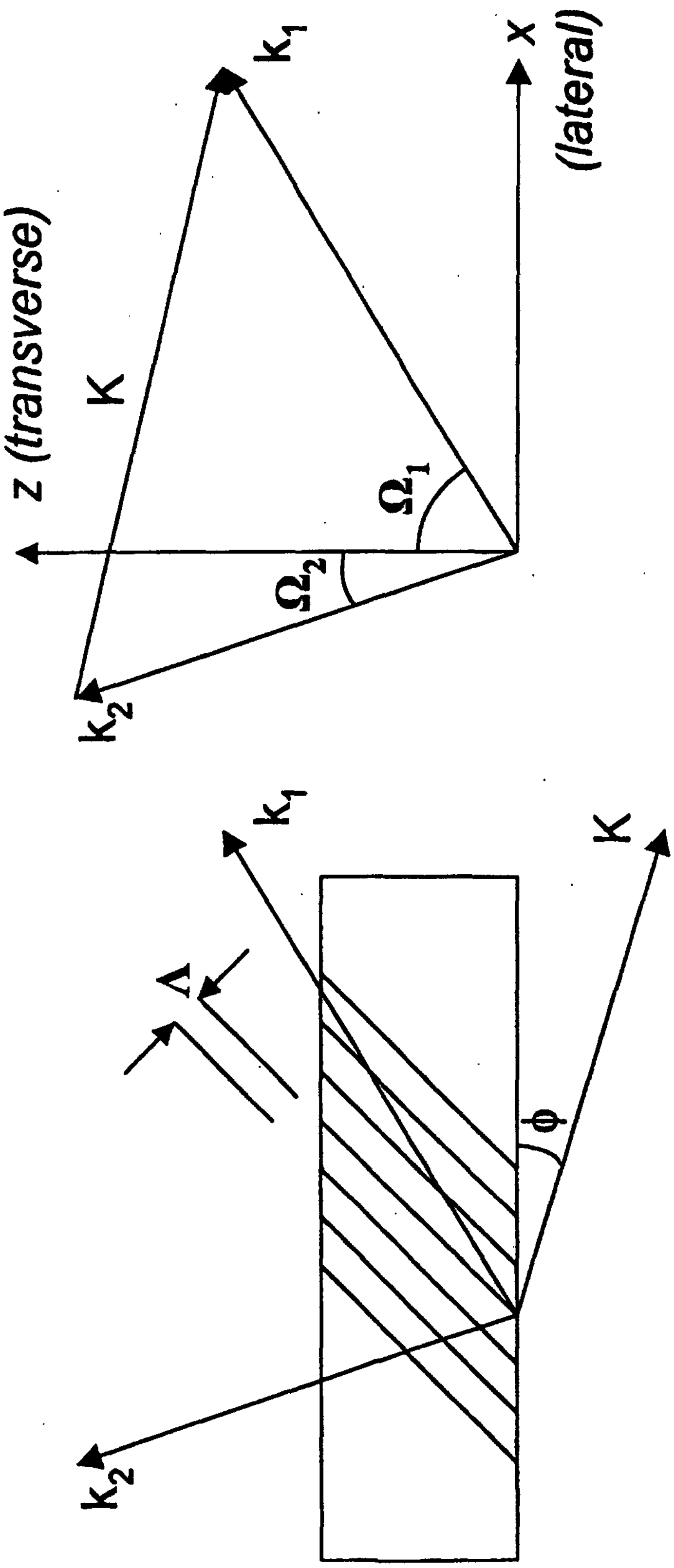
k$_1$
x
(lateral)
z (transverse)
K
$\Omega_1$
$\Omega_2$
k$_2$
k$_1$
K
$\Lambda$
$\phi$
k$_2$

Figure